# EUROPEAN PATENT APPLICATION

(11) **EP 4 517 292 A1**
(43) Date of publication of application: **05.03.2025**
(21) Application number: 24196953.4
(22) Date of filing: 28.08.2024
(51) Int. Cl.: G01N 1/28, G01N 1/42, H01J 37/20

(54) **LIQUID SPECIMEN GRID FOR TRANSMISSION ELECTRON MICROSCOPE**

(30) Priority: 28.08.2023 US 202363579234 P
(71) Applicant: FEI COMPANY, Hillsboro, OR 97124 (US)
(72) Inventor: DE RUITER, Jolet, Eindhoven (NL); HENDRIKSEN, Bas, Eindhoven (NL)
(74) Representative: Robinson, Louise Frances

(57) **Abstract**

A grid for sampling a liquid specimen. The grid includes a mesh and a foil. The mesh includes a plurality of grid bars defining a plurality of openings. The plurality of grid bars forms an outer perimeter of each opening. The foil is coupled to the mesh and the foil includes a plurality of holes. A subset of the plurality of holes is aligned with each of the plurality of openings. Each hole of the subset is spaced from the outer perimeter of the corresponding opening defined by the plurality of grid bars.

## Description

### CROSS REFERENCE TO RELATED APPLICATIONS

This application claims priority to U.S. Provisional Patent Application No. 63/579,234 filed on August 28, 2023, the entire content of which is incorporated herein by reference.

### BACKGROUND

The present disclosure relates to a grid for sampling a liquid specimen. The grid may be for sampling a liquid specimen for transmission electron microscopy (TEM) analysis.

Samples for single-particle cryo-electron microscopy are conventionally prepared by manually pipetting a buffer solution containing proteins on a glow-discharged TEM grid carrier. The grid is subsequently blotted by filter paper and vitrified in liquid ethane. When using a TEM grid with a foil that has holes, the applied sample may wet the back side of the foil ("backside wetting") by flowing through micrometer-sized holes. Backside wetting may present several issues: (1) complicating removal of liquid from the grid; or (2) complicating thinning of liquid on the grid. Removal of liquid and thinning of liquid are both necessary to obtain a thin film of the sample suitable for cryo-electron microscopy.

### SUMMARY

In one implementation, the disclosure provides a grid for sampling a liquid specimen. The grid includes a mesh and a foil. The mesh includes a plurality of grid bars defining a plurality of openings. The plurality of grid bars forms an outer perimeter of each opening. The foil is coupled to the mesh and includes a plurality of holes. A subset of the plurality of holes is aligned with each of the plurality of openings. Each hole of the subset is spaced from the outer perimeter of the corresponding opening defined by the plurality of grid bars.

In another implementation, the disclosure provides a grid for sampling a liquid specimen. The grid includes a mesh and a foil. The mesh includes a plurality of grid bars defining a plurality of openings. The plurality of grid bars forms an outer perimeter of each opening. The foil is coupled to the mesh and the foil includes a plurality of holes. A subset of the plurality of holes is aligned with each of the plurality of openings. None of the holes of the subset partially overlaps the plurality of grid bars forming the outer perimeter of the corresponding opening.

In another implementation, the disclosure provides a method of fabricating a grid for sampling a liquid specimen. The method includes providing a foil including a plurality of holes and coupling a mesh to the foil. The mesh includes a plurality of grid bars defining a plurality of openings. The plurality of grid bars forms an outer perimeter of each opening. A subset of the plurality of holes is aligned with each of the plurality of openings. The method also includes spacing each hole of the subset from the outer perimeter of the corresponding opening defined by the plurality of grid bars.

Other aspects of the disclosure will become apparent by consideration of the detailed description and accompanying drawings.

### BRIEF DESCRIPTION OF THE DRAWINGS

FIG. 1 is a perspective view of a grid for sampling a liquid specimen.
FIG. 2A is a top schematic view of a portion of a mesh of the grid of FIG. 1.
FIG. 2B is a top schematic view of a portion of the grid of FIG. 1.
FIG. 3A is a cross-sectional, schematic view of a portion of the grid of FIG. 1 with a liquid specimen applied to a first side of the grid.
FIG. 3B is a cross-sectional, schematic view of a portion of the grid of FIG. 1 with a liquid specimen applied to a second side of the grid.
FIG. 4 is a schematic diagram of an electronic control system and a microcontroller.
FIG. 5 is a flow chart depicting a method of fabricating the grid of FIG. 1.

### DETAILED DESCRIPTION

Before any implementations of the disclosure are explained in detail, it is to be understood that the disclosure is not limited in its application to the details of construction and the arrangement of components set forth in the following description or illustrated in the following drawings. The disclosure is capable of other implementations and of being practiced or of being carried out in various ways.

The present disclosure relates to a sample preparation system 10 for sampling a liquid specimen 14. The sample preparation system 10 is configured to prepare the liquid specimen 14 for analysis by a charged particle microscope (e.g., a transmission electron microscope [TEM]). The illustrated application is only one example, and the sample preparation system 10 may be utilized in any sampling application, especially when sampling a liquid specimen 14.

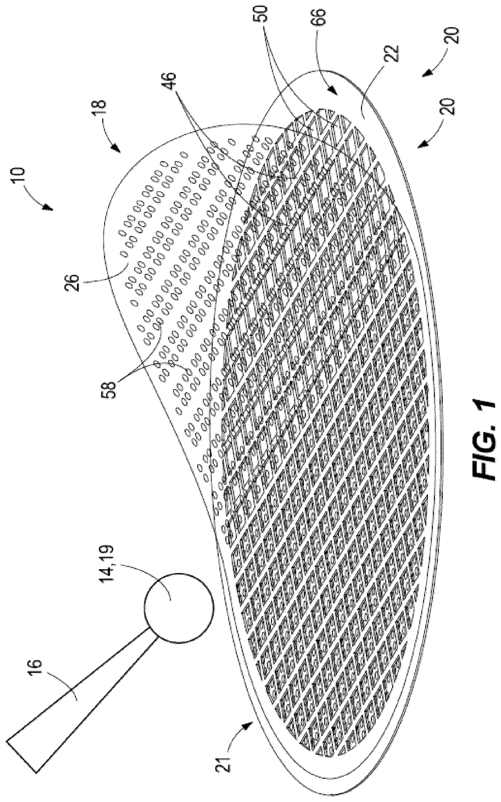

As illustrated in FIG. 1, the sample preparation system 10 includes a pipette 16 for placing the liquid specimen 14 and a grid 18 for holding the liquid specimen 14. The pipette 16 is configured to place a droplet 19 of the liquid specimen 14 onto the grid 18. In other embodiments, a different device may be used to place the liquid specimen 14 onto the grid 18 (e.g., a printer, syringe, etc.). The pipette 16 is configured to place the droplets 19 onto a second side 20 of the grid 18. In alternate embodiments, the pipette 16 may place the droplets 19 onto a first side 21 of the grid 18.

The illustrated grid 18 includes a mesh 22 and a foil 26. The foil 26 defines the first side 21 of the grid 18. The mesh 22 defines the second side 20 of the grid 18. The mesh 22 and the foil 26 are substantially the same shape and size. In the illustrated embodiment, both the mesh 22 and the foil 26 are circular in shape. In alternate embodiments, the mesh 22 and the foil 26 may be a different shape (e.g., square, rectangular, trapezoidal, etc.), or the mesh 22 may have a different shape from the foil 26 (e.g., the mesh 22 may be circular and the foil 26 may be square).

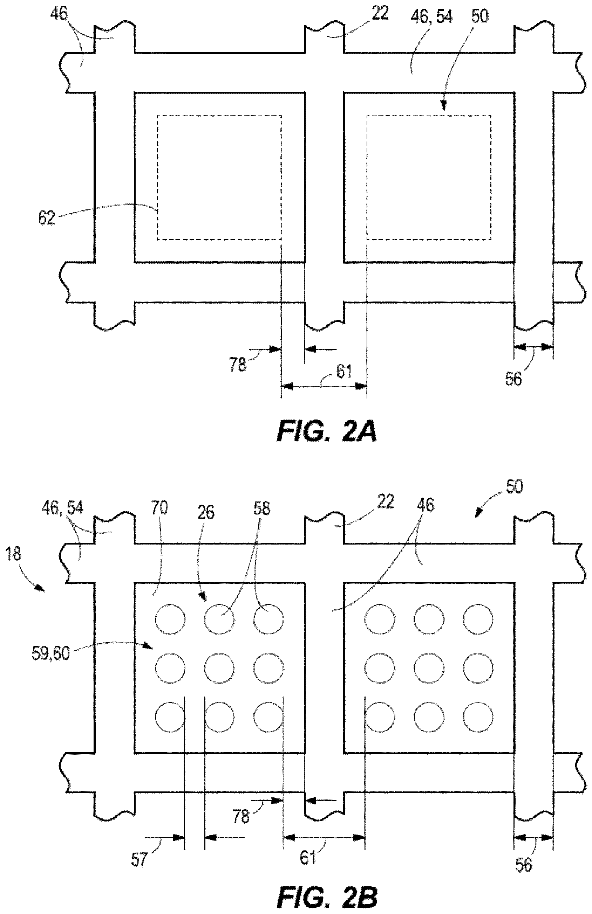

The mesh 22 includes a plurality of grid bars 46 defining a plurality of openings 50. As shown in FIGS. 2A and 2B, each of the illustrated openings 50 is generally square in shape. In alternate embodiments, each of the plurality of openings 50 may have other shapes (e.g., circular, rectangular, hexagonal, oblong, etc.). The plurality of grid bars 46 forms an outer perimeter 54 of each of the plurality of openings 50. The outer perimeter 54 corresponds with and overlaps with the grid bars 46, as shown in FIG. 2A. Each of the plurality of grid bars 46 has a width 56. In the present embodiment, the width 56 is 25 micrometers. In other embodiments, the grid bars 46 may have other widths in a range from 10 to 100 micrometers.

In the present embodiment, the mesh 22 is hydrophilic and the foil 26 is hydrophilic. In alternate embodiments, the mesh 22 may not be hydrophilic, or the foil 26 may not be hydrophilic, or both the mesh 22 and the foil 26 may not be hydrophilic.

The foil 26 includes a plurality of holes 58. In the illustrated embodiment, each of the plurality of holes 58 is generally circular. In alternate embodiments, the plurality of holes 58 may be different shapes (e.g., square, triangular, oblong, etc.). Subsets 59 of the plurality of holes 58 are arranged in clusters 60. A cluster 60 is a collection of holes 58 that is spaced from a similar collection of holes 58. Each cluster 60 is aligned with one of the openings 50 defined by the mesh 22. The cluster 60 is separated from adjacent clusters 60 of the plurality of holes 58 by a distance 61. The distance 61 may be greater than the width 56 of one of the plurality of grid bars 46. The grid bar 46 may be dome shaped such that a contact length 62 between the grid bar 46 and the foil 26 may be smaller or larger than the mesh width 56. The contact length 62 between the grid bar 46 and the foil 26 is variable depending on the tension of the foil 26. The tension of the foil 26 determines what extent the foil 26 follows the curve of the grid bar 46. The distance 61 may be greater than the contact length 62. In the present embodiment, the foil 26 may be a plastic film. Amorphous carbon may be deposited onto the plastic film after which the plastic film may be dissolved. Alternatively, the plastic film may remain along with the amorphous carbon. In some embodiments, the mesh 22 may be built upon the foil 26 to form a one-piece mesh-foil structure and the foil 26 may be made of a metal such as gold. In other embodiments, the foil 26 may be made of a different material (e.g., plastic, glass, etc.).

A back portion 66 of the mesh 22 corresponds with and is at least partially in contact with the foil 26. The subset 59 of the plurality of holes 58 on the foil 26 is configured to align with one of the plurality of openings 50. Each hole 58 of the subset 59 is spaced apart from the outer perimeter 54 of the corresponding opening 50. In the present embodiment, none of the holes 58 of the subset 59 partially overlaps the plurality of grid bars 46 that form the outer perimeter 54 of the corresponding opening 50. Rather, a solid portion 70 of the foil 26 is in contact with the outer perimeter 54. The solid portion 70 of the foil 26 is continuous and does not include any of the plurality of holes 58. The solid portion 70 may extend along the entire contact length 62. The holes 58 are configured to align with the opening 50 to inhibit backside wetting (i.e., when a portion of the liquid specimen 14 leaks through the holes 58 and comes into contact with a second side 74 of the foil 26).

Each of the plurality of holes 58 in the cluster 60 is spaced apart from one another by a cluster distance 57. The cluster distance 57 may be less than the distance 61 that adjacent clusters 60 are separated from one another. In alternate embodiments, such as when the amount of the plurality of holes 58 is low, the cluster distance 57 may be more than the distance 61. The cluster distance 57 and the distance 61 distinguish distinct clusters 60 from one another by arranging the plurality of holes 58 at varied distances from one another. One cluster 60 may include any number of holes 58, for example, between 1 and 1000. In the example shown in FIG. 2B, one cluster 60 includes nine holes 58. In alternate embodiments, one cluster 60 may include fewer or more holes 58. The illustrated cluster 60 is arranged to create a square shape. The cluster 60 includes three holes on each side of the square shape. In alternate embodiments, the cluster 60 may be arranged in any of a plurality of different shapes (e.g., triangular, circular, rectangular, etc.).

In some embodiments, the holes 58 may be evenly spaced and distributed across the entire foil 26. In such embodiments, the clusters 60 may be defined by the grid bars 46 of the mesh 22. That is, holes 58 within the outer perimeter 54 of one opening 50 may form a first cluster 60, while holes 58 within the outer perimeter 54 of another opening 50 may form a second cluster 60. Holes 58 between adjacent clusters 60 (e.g., holes 58 that overlap with the grid bars 46) may not be considered part of any cluster.

The mesh 22 has a mesh thickness of 15 micrometers. The foil 26 has a foil thickness of 10 nanometers. In alternate embodiments, the mesh 22 and the foil 26 may have other thicknesses. For example, the mesh 22 may have a nominal mesh thickness in a range from 5-35 micrometers. The foil 26 may have a nominal foil thickness in a range from 5-50 nanometers.

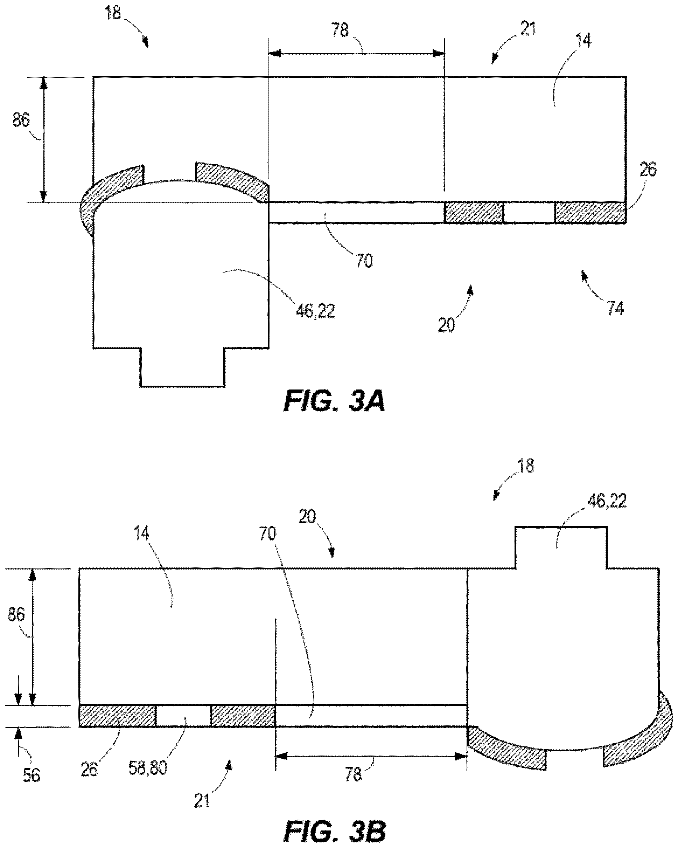

FIG. 3A illustrates a liquid specimen 14 applied onto the first side 21 of the grid 18 such that the liquid specimen 14 is supported by the foil 26. As shown in the illustrated embodiment, the foil 26 is closed near the grid bar 46. That is, none of the holes 80 in the foil 26 partially overlaps one of the grid bars 46. Rather, a first hole 80 of the subset 59 (i.e., the hole 80 nearest the grid bar 46) is formed at a hole distance 78 from the grid bar 46. The hole distance 78 may be between 5 and 20 micrometers. In other embodiments, the hole distance 78 may be larger or smaller. For example, the hole distance 78 may be in a range from 1-100 micrometers. By closing the foil 26 adjacent the grid bar 46, the liquid specimen 14 is less likely to seep through a portion of the foil 26 by clinging to the grid bar 46. As such, backside wetting may be reduced.

In alternate embodiments, the clusters 60 may only partially align across the grid 18 (i.e., some clusters 60 may be perfectly aligned and some clusters 60 may have holes 80 overlapping the grid bar 46). These grids 18 may still be usable by applying the liquid specimen 14 only to the clusters 60 having perfect alignment. Alternatively, the user may accept backside wetting in individual openings 50.

FIG. 3B illustrates a liquid specimen 14 applied onto the second side 20 of the grid 18 such that the liquid specimen 14 is supported by the foil 26 between the grid bars 46 of the mesh 22. Similar to the scenario in FIG. 3A, the foil 26 is closed near the grid bar 46. As such, the liquid specimen 14 is less likely to seep through a portion of the foil 26 adjacent the grid bar and cause backside wetting.

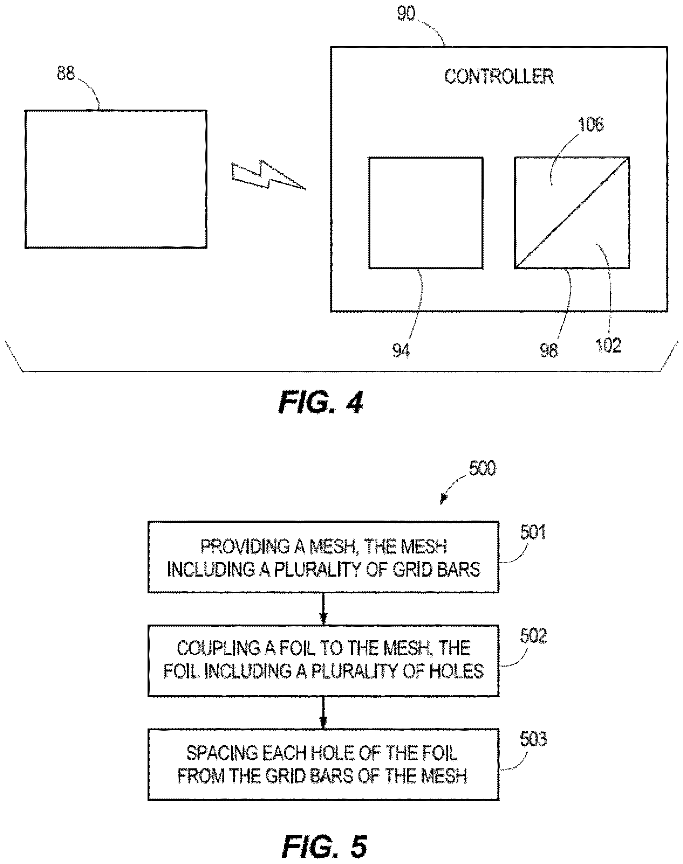

FIG. 4 illustrates the sample preparation system 10 including a micromanipulator 88 to help align the foil 26 with the mesh 22. In some embodiments, the micromanipulator 88 is configured to detect the location of the holes 58 and the location of the grid bars 46. The micromanipulator 88 then aligns the foil 26 with the mesh 22 such that each cluster 60 of the holes 58 is positioned within one of the openings 50. More particularly, the micromanipulator 88 aligns the foil 26 with the mesh 22 such that none of the holes 58 partially overlaps with any of the grid bars 46. In other embodiments, the micromanipulator 88 may detect edges or other features of the mesh 22 and the foil 26 to properly align the foil 26 with the mesh 22. The illustrated sample preparation system 10 also includes an electronic controller 90 configured to automatically or semi-automatically control the micromanipulator 88. The controller 90 may include a programmable processor 94 (e.g., a microprocessor, a microcontroller, or another suitable programmable device) and a memory 98 such as a non-transitory memory. The memory 98 may include, for example, a program storage area 102 and a data storage area 106. The program storage area 102 and the data storage area 106 can include combinations of different types of memory 98, such as read only memory ("ROM"), random access memory ("RAM") (e.g., dynamic RAM ["DRAM"], synchronous DRAM ["SDRAM"], etc.), electrically erasable programmable read-only memory ("EEPROM"), flash memory, a hard disk, an SD card, or other suitable magnetic, optical, physical, electronic memory devices, or other data structures. Programming may be coded or learned.

As one example, the electronic controller 90 may be configured to control rotation and movement of the micromanipulator 88. The electronic controller 90 may also be configured to control the position of the micromanipulator 88 in 3-dimensional space, e.g., to move or rotate the micromanipulator 88 to align the mesh 22 with the foil 26, which may include moving in the X-direction, the Y-direction, and/or the Z-direction, in any combination or orientation.

In some embodiments, the foil 26 may be initially solid and not include the plurality of holes 58. In such embodiments, the back portion 66 of the mesh 22 may be aligned with the foil 26 and attached to the foil 26. The plurality of holes 58 may then be formed in the foil 26 after the foil 26 is coupled to the mesh 22. For example, a patterning device may pattern the plurality of holes 58 on a portion of the foil 26 corresponding to the opening 50. The patterning device may be controlled by the electronic controller 90. This may occur using wafer-based manufacturing (i.e., the grid 18 is produced on a silicon wafer). Wafer-based manufacturing allows for an addition of custom fiducial markers and patterns which aid in locating and identifying particular regions of the grid 18 at several length scales: by eye, in an optical microscope, and in the electron microscope. These fiducial markers aid in the patterning of the plurality of holes 58 on the foil 26. In other embodiments, the micromanipulator 88 may align a template to the pre-aligned mesh 22 and foil 26. The template may be configured to aid in the patterning of the plurality of holes 58 on the foil 26. Alternatively, the mesh 22 and the foil 26 may not be aligned and instead the mesh may be built upon the foil to form the one-piece closed mesh-foil structure. The patterning device may then pattern the plurality of holes 58 on the portion of the foil corresponding to the opening 50. In alternate embodiments, the foil 26 may include the plurality of holes 58 and a pre-made mesh 22 may be aligned with the foil using the micromanipulator 88. Alternatively, the foil 26 may include the plurality of holes 58 and the mesh 22 may be built upon the foil 26 to create the integrally formed one-piece mesh-foil structure.

In further embodiments, the foil 26 may have holes 58 all over and some of the holes 58 may be filled after the foil 26 is attached to the mesh 22. For example, if the foil 26 is positioned on the mesh 22 such that some holes 58 do partially overlap with the grid bars 46, the holes 58 that partially overlap with the grid bars 46 may be filled with a suitable material or filler to close those holes 58. The foil 26 may be attached to the mesh 22 using the micromanipulator 88, or the mesh 22 may be built upon the foil 26 to form the one-piece mesh-foil structure.

FIG. 5 is a flowchart depicting a method 500 of fabricating the grid 18 for sampling the liquid specimen 14 for analysis in a charged particle microscope (e.g., a transmission electron microscope, scanning electron microscope, etc.). Although the method includes particular steps, not all of the steps need to be performed or need to be performed in the order presented. In some embodiments, the method may include additional steps. At least some of the method may be carried out by the electronic controller 90.

At step 501, a user provides the foil 26. Step 501 may also include the user providing the mesh 22. The foil 26 may include the plurality of holes 58. The subset 59 of the plurality of holes 58 is arranged in the cluster 60. The cluster 60 is separated from adjacent clusters 60 of the plurality of holes 58 by the distance 61. Alternatively, the foil 26 may not include the plurality of holes 58 at this step 501.

At step 502, the mesh 22 is added to the foil 26. This may be done by a user or by a micromanipulator 88. The mesh 22 includes the plurality of grid bars 46. The plurality of grid bars 46 defines the plurality of openings 50 and forms the outer perimeter 54 of each opening 50. Each of the plurality of openings 50 is generally square in shape. The mesh may be built upon the foil to form the one-piece closed mesh-foil structure. The cluster 60 is aligned with each of the plurality of openings 50 after the mesh 22 and the foil 26 are coupled. The mesh 22 may be added to the foil 26 using any of a plurality of different adhesives or adhesive techniques. In some embodiments, an adhesive or adhesive technique may not be used.

At step 503, each hole 58 of the subset 59 is spaced from the outer perimeter 54 of the corresponding opening 50 defined by the plurality of grid bars 46. In some embodiments of the present method, step 503 may include aligning the foil 26 with the mesh 22 such that none of the holes 58 of the subset 59 partially overlaps the plurality of grid bars 46. Step 503 may further include filling any holes 58 of the subset 59 that partially overlap the plurality of grid bars 46. In some embodiments, a patterning device may pattern the plurality of holes 58 on the portion of the foil 26 corresponding to the openings 50. The patterning device may not pattern holes 58 on the outer perimeter 54. Further method steps and intermediary method steps are apparent from the description above and the operational description below.

In operation, the foil 26 and the mesh 22 are aligned to form the grid 18 such that the holes 58 only align with the opening 50. The holes 58 do not partially overlap with the plurality of grid bars 46. The liquid specimen 14 is pipetted onto the grid 18, and the user blots the grid 18 with filter paper. The grid 18 is then inserted into, for example, liquid ethane to vitrify the liquid solution. The grid 18 may be submerged into a bath of liquid ethane or a jet of liquid ethane may be focused on the grid 18. The grid 18 may then be analyzed by the microscope (e.g., TEM). It should be noted that other preparation techniques may be used. For example, a printer may print the liquid specimen 14 onto the grid 18, and the user may not be required to blot the grid.

Aligning the subset of holes with each of the plurality of openings provides advantages. If a hole partially overlaps with the grid bar 46, back side wetting may occur due to the hydrophilicity of the grid bars 46. This may cause a backside meniscus to grow from the grid bars 46 inward toward the center of the opening 50. This may lead to poorly reproducible sample thickness 86 and thick ice unsuitable for cryo-EM acquisition in large areas of the grid 18. By keeping the foil 26 solid near the grid bars 46, back side wetting may be less likely to occur and there may be better control over sample thickness 86.

Various features and advantages of the invention are set forth in the following claims.

## Claims

1. A grid for sampling a liquid specimen, the grid comprising:
a mesh including a plurality of grid bars defining a plurality of openings, the plurality of grid bars forming an outer perimeter of each opening; and
a foil coupled to the mesh, the foil including a plurality of holes, wherein a subset of the plurality of holes is aligned with each of the plurality of openings, and wherein each hole of the subset is spaced from the outer perimeter of the corresponding opening defined by the plurality of grid bars.

2. The grid of claim 1, wherein each of the plurality of openings is generally square.

3. The grid of claim 2, wherein each of the plurality of holes is generally circular.

4. The grid of claim 1, wherein the foil is a plastic film.

5. The grid of claim 1, wherein the mesh is hydrophilic.

6. The grid of claim 1, wherein each subset of the plurality of holes is arranged in a cluster separated from adjacent clusters of the plurality of holes by a distance greater than a width of one of the plurality of grid bars.

7. The grid of claim 1, wherein the mesh has a mesh thickness of 5-35 micrometers.

8. The grid of claim 1, wherein the foil has a foil thickness of 10-15 nanometers.

9. A grid for sampling a liquid specimen, the grid comprising:
a mesh including a plurality of grid bars defining a plurality of openings, the plurality of grid bars forming an outer perimeter of each opening; and
a foil coupled to the mesh, the foil including a plurality of holes, wherein a subset of the plurality of holes is aligned with each of the plurality of openings, and wherein none of the holes of the subset partially overlaps the plurality of grid bars forming the outer perimeter of the corresponding opening.

10. The grid of claim 9, wherein each of the plurality of openings is generally square.

11. The grid of claim 10, wherein each of the plurality of holes is generally circular.

12. The grid of claim 9, wherein the foil is a plastic film.

13. The grid of claim 9, wherein the mesh is hydrophilic.

14. The grid of claim 9, wherein each subset of the plurality of holes is arranged in a cluster separated from adjacent clusters of the plurality of holes by a distance greater than a width of one of the plurality of grid bars.

15. The grid of claim 9, wherein the mesh has a mesh thickness of 5-35 micrometers.

16. The grid of claim 9, wherein the foil has a foil thickness of 10-15 nanometers.

17. A method of fabricating a grid for sampling a liquid specimen, the method comprising:
providing a foil including a plurality of holes;
coupling a mesh to the foil, the mesh including a plurality of grid bars defining a plurality of openings, the plurality of grid bars forming an outer perimeter of each opening, wherein a subset of the plurality of holes is aligned with each of the plurality of openings; and
spacing each hole of the subset from the outer perimeter of the corresponding opening defined by the plurality of grid bars.

18. The method of claim 17, wherein spacing each hole of the subset from the outer perimeter of the corresponding opening includes aligning the foil with the mesh such that none of the holes of the subset partially overlaps the plurality of grid bars.

19. The method of claim 17, wherein spacing each hole of the subset from the outer perimeter of the corresponding opening includes filling any holes of the subset that partially overlap the plurality of grid bars.

20. The method of claim 17, wherein spacing each hole of the subset from the outer perimeter of the corresponding opening includes forming the plurality of holes in the foil after the foil is coupled to the mesh.
